# EUROPÄISCHE PATENTSCHRIFT

(11) **EP 4 145 703 B1**
(45) Veröffentlichungstag und Bekanntmachung des Hinweises auf die Patenterteilung: **05.03.2025**
(21) Anmeldenummer: 22188219.4
(22) Anmeldetag: 02.08.2022
(51) Int. Cl.: H03K 17/95, G01D 5/22, G01V 3/10, H05K 1/16

(54) **MINIATURISIERTER, INDUKTIVER NÄHERUNGSSENSOR UND VERFAHREN ZUR DETEKTION EINES ERFASSUNGSKÖRPERS**
MINIATURIZED INDUCTIVE PROXIMITY SENSOR AND METHOD FOR DETECTING A DETECTION BODY
CAPTEUR DE PROXIMITÉ INDUCTIF MINIATURISÉ ET PROCÉDÉ DE DÉTECTION D'UN CORPS À DÉTECTER

(30) Priorität: 03.09.2021 DE 102021122810
(43) Veröffentlichungstag der Anmeldung: 08.03.2023
(73) Patentinhaber: Turck Holding GmbH, 58553 Halver (DE)
(72) Erfinder: Faber, Michael, 58762 Altena (DE)
(74) Vertreter: DTS Patent- und Rechtsanwälte PartmbB

(56) Entgegenhaltungen:
- DE-B3- 102012 214 330
- JP-A- 2008 058 241
- US-A1- 2017 302 273
- US-A1- 2017 345 548
- US-A1- 2018 308 617
- US-A1- 2021 132 120

## Beschreibung

Die vorliegende Erfindung betrifft einen induktiven Näherungssensor nach dem Oberbegriff des Anspruchs 1 und ein Erfassungsverfahren nach dem Oberbegriff des Anspruchs 12.

Stand der Technik sind induktive Näherungssensoren bekannt. Eine solche Anordnung zeigt beispielsweise die DE 10 2006 053 023 A1, welche planare Sendespulenanordnung vorschlägt, mit einer ein magnetisches Wechselfeld erzeugenden Sendespule. Weiterhin schlägt die DE 10 2006 053 023 A1 vor, die Windungen der Spulen in gedruckter Art und Weise auf einer Trägerplatine vorzusehen. Durch die gemeinsame Kompensationsspule und von ihr erzeugte äußere Feld und dessen Feldlinien, kommt es zu einer Kompensation der Feldlinien der Sendespule im Umgebungsbereich, so dass insgesamt der Fluss im Umgebungsbereich Null oder im Wesentlichen Null gebracht werden kann. Gemäß der DE 10 2006 053 023 A1 ist die Empfangsspule zwischen Sendespule und Kompensations-Sendespule angeordnet.

Aus der US 2017/302273 A1 ist ein Sensorelement eines induktiven Entfernungssensors bekannt. Die US 2017/345548 A1 beschreibt eine gestapelte Spule für eine drahtlose Ladestruktur.

Es hat sich herausgestellt, dass derartige Spulen nur sehr bedingt miniaturisiert werden können, weil die störenden Einflüsse beispielsweise Leitungswegen, angrenzenden Kontaktstellen überproportional groß werden.

Es ist die Aufgabe der vorliegenden Erfindung eine verbesserte Bauform für sehr kleine induktive Näherungssensoren vorzuschlagen, die die vorgenannten Nachteile vermeiden.

Diese Aufgabe wird erfindungsgemäß gelöst durch einen miniaturisierten, induktiven Näherungsschalten nach den Merkmalen des Anspruchs 1 und einem Erfassungsverfahren nach den Merkmalen des Anspruches 11. Vorteilhafte Ausgestaltungen sind in den jeweiligen, zugehörigen Unteransprüchen angegeben.

Danach wird die Aufgabe gelöst durch einen induktiven Näherungssensor zur Detektion eines Erfassungskörpers, der zwei Empfangsspulen und eine Sendespule umfasst, die jeweils aus einer Gruppe von mindestens zwei Einzelspulen auf Trägerplatinen gebildet sind, welche zueinander parallel ausgerichtet und axial versetzt als Stapel entlang einer gemeinsame Sensorachse angeordnet sind, wobei die Sendespule zwischen den beiden Empfangsspulen angeordnet ist, und wobei die Trägerplatinen der Einzelspulen einen Durchmesser aufweisen, der kleiner oder gleich 10 mm beträgt. Hierbei weist die Windung der Empfangsspule und/oder Sendespule eine Querschnittsgeometrie auf, bei der das Verhältnis von Höhe zur Fußbreite im Bereich von 0,2 bis 0,3 liegt, idealerweise zwischen 0,23 und 0,27.

Die Spulenanordnung wird durch einen Oszillator und/oder einen Generator zu einem schwingenden Wechselfeld angeregt, insbesondere ist die Verschaltung derart angelegt, dass ein in Resonanzfrequenz schwingendes, selbstanregendes Wechselfeld gebildet wird.

Vorteilhafterweise übersteigt die Höhe der Windung 0,05mm nicht, insbesondere ist sie maximal 0,04mm.

Bei Spulensystemen im Stand der Technik werden Windungen aufgedruckt, die regelmäßig eine Fußbreite von ca. 0,14 mm und eine Höhe über der Trägerplatine von 0,014 aufweisen. Als vorteilhafter Effekt hat sich herausgestellt, dass es vorteilhaft nicht, den Querschnitt nicht linear zu verkleinern, ausgehend von den im Stand der Technik bekannten Querschnitten, sondern eine proportional größere Höhe vorzusehen. Hierdurch wird ein zu hoher ohmscher Widerstand in den jeweiligen Spulen vermieden und engere Windungen sind möglich.

Nachfolgend werden die Begriffe "Einzelspule" und "Trägerplatine" (mit einer dort angebrachten Windung einer Einzelspule) synonym verwendet, wenn nicht ausdrücklich etwas anderes ausgeführt ist.

Eine verbesserte Ausführungsform sieht vor, dass die Windungszahl von mindestens einer Einzelspule der Empfangsspulen gleich oder größer als 3 ist, idealerweise 4 oder 5 beträgt, insbesondere alle Einzelspulen der Empfangsspulen gleich oder größer als 3 ist, idealerweise 4 oder 5 beträgt. Es hat nicht überraschenderweise gezeigt, dass zum Aufbau einer hinreichenden Induktivität bei sehr begrenzten Belegungsflächen ein Optimum darstellt. Weiterhin besteht eine weiter verbesserte Ausführungsform darin, dass die Windungszahl von mindestens einer Einzelspule der Sendespule gleich oder größer als 3 ist, idealerweise 3 oder 4 beträgt, insbesondere alle Einzelspulen der Empfangsspulen gleich oder größer als 3 ist, idealerweise 3 oder 4 beträgt.

Hierbei sind Windungszahlen nicht als geradzahlige, absolute 360°-Umläufe zu verstehen, sondern es meint eine Windungszahl X den x-fachen Umlauf von 360° plus einen Anteil von 360°. Anders ausgedrückt umfasst beispielsweise die Windungsanzahl "4" auch absoluten Windungs-/Umlaufzahlen von 4,25 oder 4,5 meint, aber nicht mehr die Windungs-/Umlaufzahl "5".

Vorteilhafterweise ist der aus Einzelspulen und Trägerplatinen gebildet Stapel symmetrisch zu einer zur Sensorachse vertikal angeordneten, mittleren Symmetrieebene) angeordnet ist, wobei eine mittlere Einzelspule der Sendespule in der Symmetrieebene liegen kann. Hierbei kann eine mechanisch-konstruktive Symmetrieebene bezüglich der axialen Lage etwas unterschiedlich angeordnet sein zu einer parallelen, elektrischen Symmetrieebene, die durch eine Einzelspule gebildet werden kann. Diese Differenz kann durch den Abgleich der Differenzspannung mittels parallel geschalteter, insbesondere regelbarer Widerstände ausgeglichen werden.

Vorteilhafterweise umfasst die Verschaltung auch einen Mess- und Regelkreis oder ist hiermit verbunden, mittels welchem über mindestens eine Einzelspule, insbesondere der einen an der Endplatine anliegenden beziehungsweise gegenüberliegenden Einzelspule, ein Widerstand gegen Masse zur Kompensation von insbesondere Phasenverschiebungen eingekoppelt werden kann. Vorteilhafterweise umfasst der Mess- und Regelkreis ein Potentiometer. Auf diese Weise können Fertigungstoleranzen und Werkstoffeinflüsse insbesondere in den Leitungsbahnen und Spulen kompensiert werden, um die Nulldifferenz der induzierten Spannungen in den Empfangsspulen beim bestimmungsgemäßen Betrieb sicher zu stellen. Die Einbindung von ausschließlich der endständigen, der Endplatine gegenüber liegenden Einzelspule der Empfangsspule hat den großen Vorteil, dass durch die kurzen Leitungswege, die vorrangig streng parallel zu der Stapelachse verlaufen, keine oder nur sehr geringe Einflüsse auf das Magnetfeld genommen werden.

Hierbei besteht eine besonders gut regel- und steuerbare Ausführungsform darin, dass die Sendespule eine Anzahl von n Einzelspulen aufweist und die beiden Empfangsspulen gemeinsam eine Anzahl von mindestens n+1 Einzelspulen aufweisen.

Hierbei ist der Begriff "Ebene" nicht im mathematischen Sinne als rein zweidimensionales Gebilde zu versehen, sondern kann auch ein sehr flacher, theoretischer Raum oder Korridor sein, der die jeweiligen Elemente umspannt und/oder aufnimmt.

Zur weiteren Platzreduktion ist es vorteilhaft, wenn mindestens eine der Trägerplatinen als Doppelträgerplatine ausgebildet, die auf beiden Oberflächenseiten eine Einzelspule beziehungsweise die Spulenwindungen aufweist. Vorteilhafterweise ist die mindestens eine als Doppelträgerplatine ausgebildete Trägerplatine auf der einen Seiten als eine Einzelspule der Empfangsspule ausgebildet und auf der anderen Oberflächenseite als eine Einzelspule der Sendespule.

Es ist eine Kopfplatine vorgesehen, die als Interface mit Anschlusspads, insbesondere genau vier Anschlusspads, für die stromleitende Verbindung mit einer einen Oszillator und/oder Generator umfassenden Verschaltung dient und welche keine (Einzel-)Spule aufweist. Bei einer weiter verbesserten Ausführungsform kann die Kopfplatine zusätzliche Anschluss- oder Kontaktpads aufweisen, für ein oder mehrere Messpunkte und/oder einen Mess- und Regelkreis, in den mindestens eine Einzelspule, insbesondere die zur Kopfplatine benachbarte Einzelspule eingebunden ist.

Weil mit vorschreitender Miniaturisierung des induktiven Sensors und der Einzelspulen der negative Einfluss von allen metallischen Flächen und Leitern(-bahnen) auf das Magnetfeld stark zunimmt, ist idealerweise auf keiner der Einzelspulen eine Zusammenführung von Leitern oder Leitungspfaden vorgesehen, außerhalb der unmittelbaren Verbindung mit der benachbarten oder zugehörigen Einzelspulen. Nur die Kopfplatine weist metallische Anschlusspads auf, zur Verbindung mit einer den Oszillator umfassenden Verschaltung und nur auf der Kopfplatine kommen mehrere Leiter oder Leitungsbahnen unterschiedlicher (Einzel-)Spulen an. Dabei meint "mehrere", dass nicht nur zwei benachbarte beziehungsweise korrelierende Einzelspulen leitend verbunden werden.

Es ist also auf jeder Einzelspule, insbesondere auf den äußeren Einzelspulen der Empfangsspule keine quer zur Spulenachse verlaufenden Leitungsbahnen zur Weiterleitung oder Verbindung vorgesehen. Insbesondere erfolgen die Verbindungen von zwei Einzelspulen immer durch eine parallel zur Spulenachse geführte Verbindungsleitung oder Durchkontaktierung. Hierfür weisen die Trägerplatinen vorteilhafterweise eine Mehrzahl von Bohrungen oder Durchführungsöffnungen auf, die in Spulenachse fluchtend angeordnete sind und insbesondere gemeinsam für die über mehrere Platinen hinwegverlaufenden Leitungswege eine Art Kanal oder Schacht bilden. In einer Teilzahl der fluchtenden Bohrungen beziehungsweise der Schächte sind elektrische Leiter geführt oder die Bohrungen oder Schächte sind mit einem elektrisch leitenden Material ausfüllt. Vorteilhafterweise ragen mindestens vier der Schächte bis in die als Interface ausgebildete Kopfplatine und enden direkt an einem Anschlusspad oder sind auf der Rückseite, das heißt auf der von dem Platinenstapel abgewandten Seite, über eine Leitungsbahn mit einem der Anschlusspads verbunden.

Die Bohrungsöffnung auf der Seite der Trägerplatine, auf welcher eine zu verbindende (Einzel-)Spule angeordnet ist, dient dabei als Löt- und Anschlusspunkt oder ist als ein solcher aufgebaut. Die jeweilige Einzelspule wird in bekannter Weise über eine Leitungsbahn mit dem parallel zur Stapelachse in den Bohrungen beziehungsweise dem Schacht geführten Leiter verbunden.

Dabei weist die Kopfplatine vorteilhafterweise genau vier Anschlusspads aufweist, je zwei Anschlusspads für die Zu- und Ableitung der in Reihe geschalteten Empfangsspulen und je zwei Anschlusspads für die Zu- und Ableitung der Sendespule. Wie vorstehend ausgeführt, können weitere Anschlusspads für Messpunkte und/oder mindestens einen Mess- und Regelkreis vorgesehen sein. Energetisch besonders vorteilhaft ist die Bildung eines selbstanregenden Systems. Hierzu sieht eine besonders vorteilhafte Ausführungsform vor, dass nur ein Oszillator ohne (aktiven) Generator vorgesehen ist. Hierbei wird über die als Induktivität wirkende Sendespule und einen parallelen Kondensator ein LC-Resonator gebildet. Dieser ist in Reihe mit dem Verstärker und den Sensorspulen bzw. den zugehörigen Kompensationsspulen zu einem LC Oszillator verschaltet, wobei ein Wechselfeld erzeugt werden kann. Dieses Wechselfeld ist insbesondere ein in Resonanzfrequenz schwingendes, selbstanregendes Wechselfeld.

Von der Erfindung ist weiterhin ein Verfahren zur Detektion eines Erfassungskörpers mittels eines induktiven Näherungssensor umfasst, der einen Außendurchmesser von gleich oder kleiner als 10mm aufweist und nach einem der vorstehend genannten Ausführungsvarianten ausgebildet ist. Dabei weist der Näherungssensor eine Kopfplatine auf, die als Interface mit Anschlusspads für den Anschluss mit einer einen Generator und/oder Oszillator umfassende Verschaltung dient und welche keine Spule aufweist.

Weitere Einzelheiten und Vorteile der Erfindung sollen nun anhand eines in den Zeichnungen dargestellten Ausführungsbeispiels näher erläutert werden.

Es zeigen:
- Fig. 1: den Näherungssensor mit einer Einzelspule und eine zugehörige Verschaltung,
- Fig. 2: eine einzelne Trägerplatine,
- Fig. 3: einen Spulenstapel in einer Schnittdarstellung,
- Fig. 4: die Einzelspulen eines Spulenstapels als Draufsicht und
- Fig. 5: ein Kopfplatine in Draufsicht.

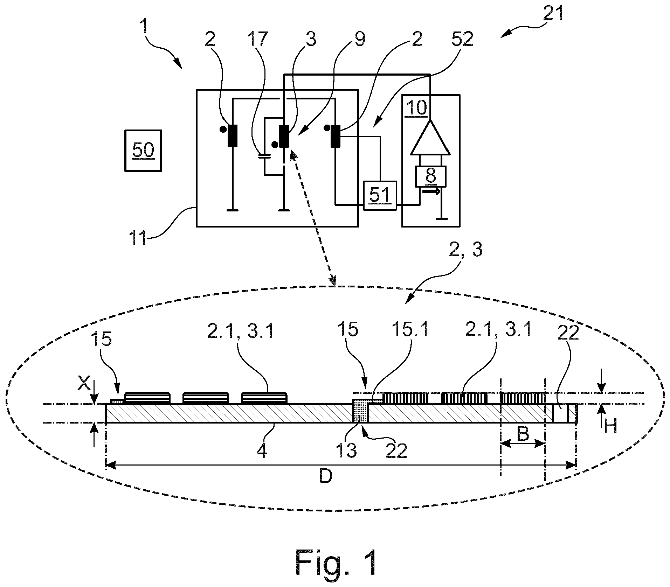

Fig. 1 zeigt einen schematischen Aufbau des Näherungssensors 1, der aus drei Gruppen von Einzelspulen aufgebaut ist. Dies sind zwei Empfangsspulen 2, zwischen denen eine Sendespule 3 angeordnet ist. Dieser induktive Näherungssensor 1 dient zur Detektion eines metallischen Erfassungsgegenstandes 50 und umfasst ein Gehäuse 11, das in der Regel eine zylindrische oder viereckige Grundfläche aufweist. Wie in der Figur 1 zu sehen, ist der Näherungssensor 1 mit einer Verschaltung 21 verbunden und wird von einem Oszillator 9 über eine Sendespule 3, die als Induktivität zusammen mit einem Kondensator 17 einen LC-Schwingkreis des Oszillators 9 bildet, ein selbstanregendes Wechselfeld erzeugt. Ein typisches Oszillationssignal liegt im Bereich von 3 - 10 MHz. Die beiden gegenläufig gewickelten Empfangsspulen 2 sind in unmittelbarer Differenzschaltung angeordnet. Die sich ergebende Differenzwechselspannung der beiden Empfangsspulen 2 wird an den Eingang des Verstärkers 9 geliefert und von dem Spannungsmesser 8 erfasst. Die Empfangsspulen 2 sind durch ihre räumliche Lage auf den beiden zueinander parallelen Ebenen und die jeweiligen Windungszahlen derart ausgebildet, dass die Differenzwechselspannung UD bei Annäherung eines Auslösers auf den gewünschten Ansprechabstand zu Null wird, wobei die Änderungen der Schwingungszustände in nicht dargestellter Weise erfasst und zu einem Schaltsignal gewandelt wird. Derartige Schaltungen sind dem Fachmann grundsätzlich bekannt, beispielsweise aus der DE 44 29 314 B4 oder der DE 40 31 252 C1. Auch die Auslegung derartiger Schaltungen für unterschiedliche Betriebsarten, zur materialabhängigen Erfassung (metallisch, nicht-metallisch) unterschiedlicher Gegenstände 50 ist dem Fachmann beispielsweise aus der vorgenannten DE 44 29 314 B4 bekannt.

Im vorliegenden Beispiel ist eine Mess- und Regeleinheit 51 vorgesehen, die einen Potentiometer umfasst und in nicht näherdargestellter Weise eine Einzelspule der vorderen Empfangsspule 2 in den Mess- und Regelkreis 52 einbindet, so dass eine Phasenverschiebung zwischen den beiden gegenläufig durchflossenen Empfangsspulen kompensiert werden kann. Dies erfolgt durch Reglung entsprechender Widerstände, insbesondere ohmscher Widerstände.

Die Besonderheit besteht nun darin, dass die einzelne Windungen 2.1, 3.1 eine Querschnittsgeometrie aufweisen, bei der ein Verhältnis von Höhe H zur Fußbreite B der einzelnen Windung von 0,25 besteht. In dem vorliegenden Beispiel beträgt die Fußbreite 0,14 mm und die Höhe 0,035 mm. Derartige Strukturen einer Leiterbahn werden mit einem Druckverfahren aufgetragen. Die Trägerplatine 4 ist aus einem nicht leitenden Material, wie einem PCB-Werkstoff gebildet. In dem gezeigten Beispiel beträgt der Durchmesser D der Trägerplatine 8mm und sie weist eine Höhe X von 0,068 mm auf.

Wie in der unteren Detailzeichnung dargestellt, ist die innerste Windung 2.1, 3.1 mit einer auf der Oberfläche und in der Bohrung 22 vorgesehenen inneren Leiterbahn 13 verbunden, so dass auf der Oberfläche der Löt- und Anschlusspunkt 15 ausgebildet ist. Das äußere Ende der Windung 2.1, 3.1 ist in dem gezeigten Beispiel ebenfalls mit einem Löt- und Anschlusspunkt 15 und einer äußeren Leiterbahn verbunden, die in einer nicht dargestellten, nach oben führenden Bohrung oder Durchkontaktierung, ihre Fortführung findet, um mit der darüber liegenden Einzelspule verbunden zu werden (nicht dargestellt). Es versteht sich, dass die räumlichen Angaben wie "darüber" oder "darunter" nicht einschränkend zu verstehen sind und je nach Gesamtausrichtung des Näherungssensors in analoger Weise zu verstehen sind. Mit äußeren und inneren Leiterbahnen sind deren radiale Lagen relativ zu der jeweiligen Einzelspule beziehungsweise deren Windungen gemeint.

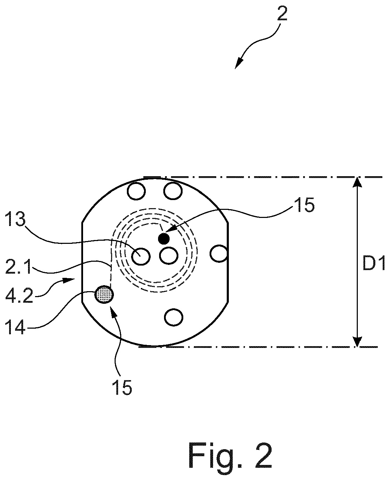

In der Figur 2 ist eine einzelne Trägerplatine 4 einer Einzelspule 2.1 der Empfangsspule 2 in der Draufsicht dargestellt. Von den vorliegend sieben Bohrungen 22 oder Durchkontaktierungen in der Trägerplatine 4, die bei allen Trägerplatinen 4 des Sensorstapels 20 vorgesehen sein können, wird für diese Trägerplatine 4 nur eine zur Versorgung genutzt, so dass diese auf der Oberfläche als Löt- und Anschlusspunkt 15 ausgebildet ist und mit einer äußeren Leiterbahn 14 und der Windung der Einzelspule 2.1 in leitender Verbindung steht. Die anderen sechs Bohrungen 22 dienen als zur Stapelachse 20 parallel geführte Leiterbahnen zur Verbindung anderer Einzelspulen oder bleiben ohne Funktion. Die sich gegenüberliegenden Abflachungen 4.2 dienen zur Lagestabilisierung und als Einführungshilfe, wobei hier alternativ auch andere Geometrien, wie Nuten, Kanten oder Führungsfinger vorgesehene sein können, die mit einem nicht dargestellten Gehäuse oder Trag- und Führungselement formschlüssig zusammenwirken.

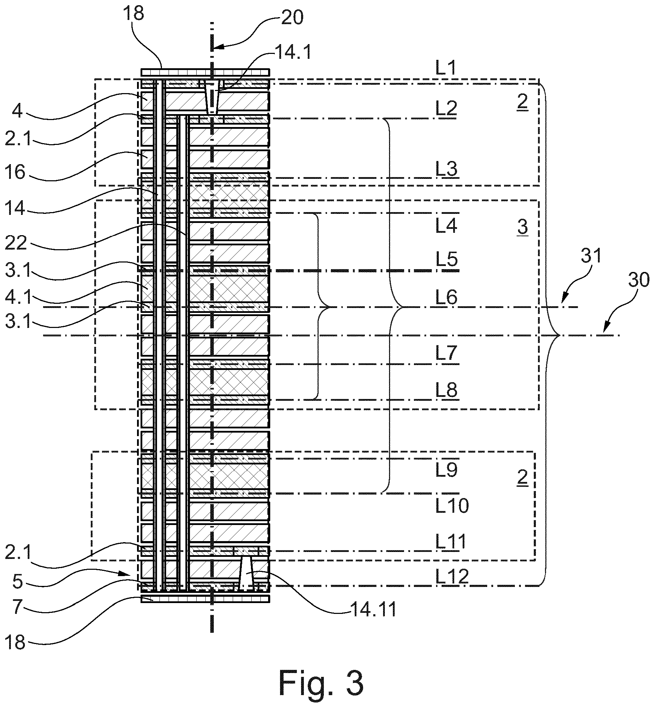

Der in Figur 3 in einer Schnittdarstellung dargestellt Sensorstapel 20 verdeutlicht die Vermeidung von metallischen Flächen und Elementen auf den Oberflächen von Trägerplatingen 4 und als Doppelträgerplatinen 4.1 ausgebildeten Einzelspulen. Die Lagen L1 bis L3 sind Teil beziehungsweise bilden die erste Empfängerspule 2 und die Lagen L9 bis L11 die zweite Empfängerspule 2. Dazwischen ist die Sendespule 3 angeordnet, die die Lagen L4 bis L8 umfasst. Die Lagen werden durch die Einzelspulen definiert. zwischen den Einzelspulen sind Dielektrika angeordnet, die entweder Trägerplatinen 4 darstellen, welche eine Einzelspule tragen oder Doppelträgerplatinen 4.1 mit beidseitigen Einzelspulen. Weiterhin sind zur Erzeugung eines streng symmetrischen Aufbaus auch Dielektrika als reine Distanzelemente 16 vorgesehen, auf deren Oberfläche keine Einzelspule aufgebracht ist. Die Lage 12 weist keine Spule auf, sondern wird im Wesentlichen durch die dortigen Anschlusspads 7, Löt- und Anschlusspunkte 15 und querlaufende Leitungsbahnen gebildet, die für die Verbindung zur nicht dargestellten Verschaltung 21 und/oder der Mess- und Regelstrecke 52 (Fig. 1) dient. Die jeweils korrelierenden Einzelspulen 2.1, 3.1 sind mit jeweils einer geschweiften Klammer zusammengefasst. Die Einzelspule der Lage 6 bildet vorliegend die elektrische Symmetrieeben 30, wobei die als strichpunktierte Linie dargestellte konstruktiv-mechanische Symmetrieebene 30 durch die mittlere Ebene zwischen den Lagen L1 und L12 gebildet wird und zwischen den Lagen L6 und L7 angeordnet ist. An beiden Enden des Stapels 20 ist jeweils eine Endplatte 18 vorgesehen.

In dem vorliegenden Beispiel ist konstruktiv-mechanische Symmetrieachse der Platinen durch den mechanischen Aufbau bestimmt und liegt bei 0,822mm Höhe des Platinen- oder Lagenstapels. Für die Funktionalität und der Abgleichbarkeit des Spulensystems auf eine induzierte Differenzspannung im gewünschten Schaltpunkt auf 0mV, müssen idealerweise die Anzahl der Lagen und Gesamtanzahl der Windungen für die Empfangsspulen L2 und L3 identisch oder nahezu identisch sein, und weiterhin die Abstände zwischen der Sendespule 3 und den beiden Empfangsspulen 2 identisch oder nahezu identisch sein.

Eine gewisse Differenz kann durch den Abgleich der Differenzspannung mittels parallel geschalteter Widerstände ausgeglichen werden, die idealerweise als regelbare Widerstände ausgebildet oder in ein Regelungsstrecke eingebunden sind. Auf diese Weise kann dem Näherungssensor ein definierter Ausgangszustand aufgeprägt werden.

Der Teil, beziehungsweise die Einzelspule, der Sendespule 3, der in Lage L6 layoutet ist, bildet die "elektrische" Symmetrieebene.

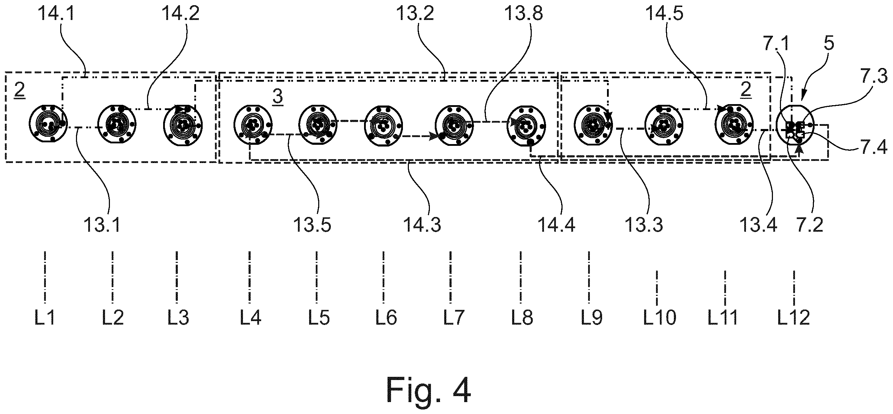

Wie in der Figur 3 und insbesondere in Figur 4 gut zu erkennen, wird auf keiner Trägerplatine 4 außerhalb der direkten Leitungsverbindung zu der jeweiligen Einzelspule 2.1, 3.1, keine Leitungsverbindung oder Kopplung quer geführt. Die links dargestellte und zur Stapelachse 20 in den Bohrungen 22 geführten äußere Leitungsbahn 14, dient zur Verbindung mit einer externen Versorgung und wird durch das Dielektrikum der Kopfplatine 5 hindurch auf deren Rückseite geführt. Erst dort wird diese mit dem Anschlusspad 7 verbunden, was üblicherweise lötend erfolgt. Analog erfolgt die Verbindung von der Kopfplatine 5 zur Einzelspule auf der Lage L11.

Weiterhin ist in dem darstellten Beispiel die Trägerplatine 4.1 für die Lagen L3 und L4 in einer Doppelfunktion ausgebildet, indem die Einzelspule der Lage L3 funktional zu ersten Empfangsspule 2 gehört und die untere Einzelspule der Lage L4 funktional zu der Sendespule 3 gehört. Die durchlaufende Bohrung 22 oder Durchkontaktierung verbindet 10 der 11 Lagen und ist eine Leitungsverbindung die nur zum Zwecke der Messung dient und einen nicht dargestellten Messpunkt zugänglich macht.

Figur 4 zeigt im Detail die leitende Verbindung 14.1 zwischen den Einzelspulen und auch zu der Kopfplatine 5 und deren Anschlusspad 7.1. die beidseitig Abflachungen 4.2 zur Lagestabilisierung und als Einführungshilfe dienen. Die in Draufsicht dargestellten Einzelspulen korrelieren mit den Lagen L1 bis L11, bzw. der Lage L12 der Kopfplatine 5, wie in der Figur 3 angedeutet. Von dem Anschlusspad 7.1 verläuft die äußere Leitungsbahn 14.1 zur Einzelspule der Lage L1 und wird nachfolgend über die Leitungsbahnen 13.1, 14.2 und die Einzelspulen der Lagen L2, L3 über eine Leitungsbahn zur Einzelspule der Lage L9 geleitet und nach durchlaufen der Einzelspulen der Lagen L10, L11 und über die Leitungsbahnen 13.3, 14.5 und 13.4 zurück zu einem Löt- und Anschlusspunkt, der mit dem Anschlusspad 7.2 der Kopfplatine 5 verbunden ist. Die Sendespule 3 ist mit der Einzelspule auf der Lage L4 über die äußere Leitungsbahn 14.3 an das das Anschlusspad 7.3 der Kopfplatine 5 angeschlossen und die Rückführung erfolgt nach analoger Durchleitung durch die Einzelspulen und Leitungsbahnen von der Einzelplatine/-spule der Lage L8 über die äußere Leitungsbahn 14.4 zum Anschlusspad 7.7. Aus Platzgründen sind die Löt- und Anschlusspunkte auf der Kopfplatine 5 zum Teil außerhalb der eigentlichen Anschlusspads, wie für die Anschlusspads 7.2, 7.4 zu erkennen.

Bei einer nicht dargestellten Ausführungsform ist eine Mess- und Regelstrecke vorgesehen, wie in Figur 1 skizziert, in die die Einzelspule auf der untersten Lage L11 eingebunden ist. Weiterhin ist mindestens ein Messpunkt beispielsweise in der Leitungsbahn 13.2 oder der äußeren Leitungsbahn 14.2 angeordnet, der mit der Mess- und Regelstrecke zusammenwirkt beziehungsweise von dieser umfasst ist. Hierüber können Toleranzen beispielsweise im Aufbau, den Leitungsbahnen oder der Spulen, die die Differenzspannung und Phasenlage beeinflussen, kompensiert werden.

Die linke Empfangsspule 2 und die mittlere Sendespule 3 sind vorliegend gleichsinnig durchflossen, nämlich entgegen dem Uhrzeigersinn in der durch Pfeile angedeuteten Stromrichtung. Die rechte Empfangsspule 2 ist gegensinnig durchflossen, in dem gezeigten Beispiel im Uhrzeigersinn. Durch die Oszillation wechseln die Stromrichtungen natürlich regelmäßig.

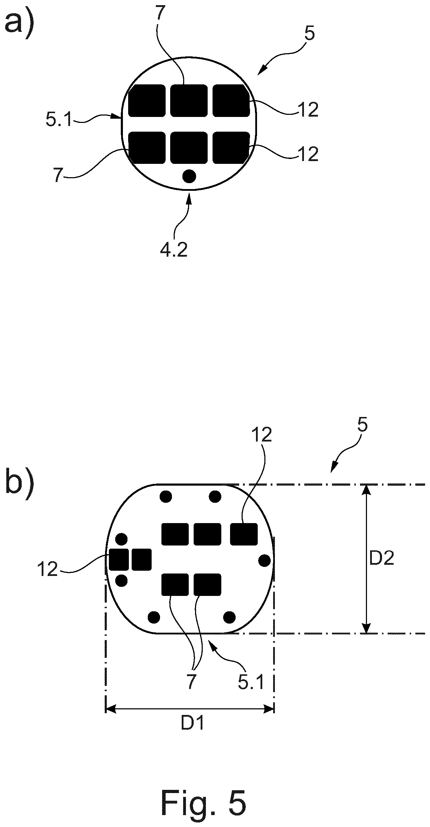

In der Figur 5a) und 5b) sind zwei Kopfplatinen 5 gezeigt. Die Kopfplatine der Figur 5a weist zwei Abflachungen 5.1 auf, analog zu den Abflachungen 4.2 der Einzelplatinen 4, um eine definierte Ausrichtung, Führung und Lage in einem Gehäuse 11 sicherzustellen. Hierbei ist der größere Durchmesser D1 = 8 mm und die Breite an den abgeflachten Bereichen D2 = 7,5 mm. Die kleinere der beiden Kopfplatinen 5 der Figur 5b weist einen Durchmesser D1 von 5,5 mm auf und eine Breite an den abgeflachten Stellen D2 von 5,0 mm.

In diesen Sensordimensionen beträgt der Schaltabstand ca. 4 mm bei einem Durchmesse D1 der Trägerplatine von 8mm, bei einem Durchmesser D1 von 5,5 mm beträgt der Schaltabstand ca. 2mm und bei einem Durchmesser D1 von 3 mm beträgt der Schaltabstand ca. 1mm.

In einer nicht dargestellten Ausführungsform ist zusätzlich ein Generator vorgesehen, der den Oszillator 9 aus Sendespule 3 und Kondensator 17 in dessen Resonanzfrequenz anregt. Alternativ kann, beim Wegfall des Kondensators 17, ein zusätzlicher Generator die Sendespule 3 in einer beliebigen Frequenz anregen.

### Bezugszeichenliste

1 Näherungsschalter
2 Empfangsspule
   2.1 Einzelspule
3 Sendespule
   3.1 Einzelspule
4 Trägerplantine
   4.1 Doppelträgerplatine
   4.2 Abflachung
5 Kopfplatine
   5.1 Abflachung
6 Spannungsmesser
7 Anschlusspad
8 Spannungsmesser
9 Oszillator
10 Verstärker
11 Gehäuse
12 Messpunkt
13 Bohrungen
14 Leiterbahn (auch 14.1 ... 14.n)
15 Löt- und Anschlusspunkt
   15.1 Leiterbahn
16 Abstandelement, Dielektrikum
17 Kondensator
18 Endplatte
19 ..
20 Stapelachse
21 Verschaltung
22 Bohrungen
30 Symmetrieebene, mechanisch
31 Symmetrieebene, elektrisch
50 Gegenstand
51 Mess- und Regeleinheit
52 Mess- und Regelstrecke
B Breite
D Durchmesser, auch D1, D2
H Höhe
X Höhe

## Patentansprüche

1. Induktiver Näherungssensor (1) zur Detektion eines Erfassungskörpers (50), umfassend zwei Empfangsspulen (2) und eine Sendespule (3), welche jeweils aus einer Gruppe von mindestens zwei Einzelspulen auf Trägerplatinen (4) gebildet sind, welche zueinander parallel und axial versetzt als Stapel (10) entlang einer gemeinsame Sensorachse (20) angeordnet sind, wobei die Sendespule (3) zwischen den beiden Empfangsspulen (2) angeordnet ist, **dadurch gekennzeichnet, dass** die Trägerplatinen (4) einen Durchmesser (D) aufweisen, der kleiner oder gleich 10 mm beträgt, wobei die Windung (2.1, 3.1) der Empfangsspule (2) und/oder die Sendespule (3) eine Querschnittsgeometrie aufweist, bei der das Verhältnis von Höhe (H) zur Fußbreite (B) im Bereich von 0,2 bis 0,3 liegt, idealerweise zwischen 0,23 und 0,27, wobei eine Kopfplatine (5) vorgesehen ist, die als Interface mit Anschlusspads (7) für den Anschluss mit einer einen Generator und/oder Oszillator (90) umfassende Verschaltung (100) dient und welche keine Spule aufweist.

2. Vorrichtung nach Anspruch 1, **dadurch gekennzeichnet, dass** die Höhe (H) 0,05mm nicht übersteigt, insbesondere 0,04mm nicht übersteigt.

3. Vorrichtung nach einem der Ansprüche 1 oder 2, **dadurch gekennzeichnet, dass** die Windungszahl von mindestens einer Einzelspule der Empfangsspulen (2) gleich oder größer als 3 ist, idealerweise 4 oder 5 beträgt, insbesondere alle Einzelspulen der Empfangsspulen (2) gleich oder größer als 3 ist, idealerweise 4 oder 5 beträgt.

4. Vorrichtung nach einem der vorherigen Ansprüche, **dadurch gekennzeichnet, dass** die Windungszahl von mindestens einer Einzelspule der Sendespule (3) gleich oder größer als 3 ist, idealerweise 3 oder 4 beträgt, insbesondere alle Einzelspulen der Empfangsspulen (2) gleich oder größer als 3 ist, idealerweise 3 oder 4 beträgt.

5. Vorrichtung nach einem der vorherigen Ansprüche, **dadurch gekennzeichnet, dass** der aus Einzelspulen und Trägerplatinen (4) gebildet Stapel (10) symmetrisch zu einer zur Sensorachse (20) vertikal angeordneten, mittleren Symmetrieebene (30) angeordnet ist, wobei eine mittlere Einzelspule der Sendespule (3) in der Symmetrieebene (30) liegen kann.

6. Vorrichtung nach einem der vorherigen Ansprüche, **dadurch gekennzeichnet, dass** die Sendespule (3) eine Anzahl von n Einzelspulen aufweist und die beiden Empfangsspulen (2) gemeinsam eine Anzahl von mindestens n+1 Einzelspulen aufweisen.

7. Vorrichtung nach einem der vorherigen Ansprüche, **dadurch gekennzeichnet, dass** mindestens eine Trägerplatine (4) als Doppelträgerplatine ausgebildet ist, die auf beiden Seiten eine Einzelspule aufweist.

8. Vorrichtung nach Anspruch 7, **dadurch gekennzeichnet, dass** die mindestens eine als Doppelträgerplatine ausgebildete Trägerplatine (4) auf der einen Seiten eine Einzelspule der Empfangsspule (2) und auf der anderen Seite eine Einzelspule der Sendespule (3) aufweist.

9. Vorrichtung nach einem der vorherigen Ansprüche, **dadurch gekennzeichnet, dass** eine Kopfplatine (5) genau vier Anschlusspads (7) aufweist, je zwei Anschlusspads (7) für die Empfangsspulen (2) und je zwei Anschlusspads (7) für die Sendespule (3).

10. Vorrichtung nach einem der vorherigen Ansprüche, **dadurch gekennzeichnet, dass** auf jeder Einzelspule, insbesondere auf den äußeren Einzelspulen der Empfangsspule (2) keine quer zur Spulenachse (20) verlaufenden Leitungsbahnen (14) zur Weiterleitung oder Verbindung mit einer nur eine jeweils eine Leitungsbahn (14) eine Kopfplatine (5) vorgesehen ist, die als Interface für den Anschluss mit der Verschaltung (21) dient und welche keine Spule aufweist.

11. Verfahren zur Detektion eines Erfassungskörpers (50) mittels eine induktiven Näherungssensor (1), wobei der induktive Näherungsschalter (1) einen Außendurchmesser (D1) von gleich oder kleiner als 10 mm aufweist und nach einem der vorherigen Ansprüche ausgebildet ist.

## Claims

1. Inductive proximity sensor (1) for detecting a sensing body (50), comprising two receiving coils (2) and one transmitting coil (3), each of which is formed from a group of at least two individual coils on carrier boards (4), which are arranged parallel to each other and axially offset in the form of a stack (10) along a common sensor axis (20), wherein the transmitting coil (3) is arranged between the two receiving coils (2), **characterized in that**
the carrier boards (4) have a diameter (D) which is less than or equal to 10 mm, wherein the turn (2.1, 3.1) of the receiving coil (2) and/or the transmitting coil (3) has a cross-sectional geometry in the case of which the ratio of height (H) to foot width (B) lies in the range of from 0.2 to 0.3, ideally between 0.23 and 0.27, wherein a head board (5) is provided, which serves as an interface with connection pads (7) for connection with a circuit (100) comprising a generator and/or oscillator (90) and which does not have a coil.

2. Device according to Claim 1, **characterized in that** the height (H) does not exceed 0.05 mm, in particular does not exceed 0.04 mm.

3. Device according to either of Claims 1 and 2, **characterized in that** the number of turns of at least one individual coil from amongst the receiving coils (2) is equal to or greater than 3, ideally is 4 or 5, in particular all individual coils from amongst the receiving coils (2) is equal to or greater than 3, ideally is 4 or 5.

4. Device according to any of the preceding claims, **characterized in that** the number of turns of at least one individual coil of the receiving coil (3) is equal to or greater than 3, ideally is 3 or 4, in particular all individual coils from amongst the receiving coils (2) is equal to or greater than 3, ideally is 3 or 4.

5. Device according to any of the preceding claims, **characterized in that** the stack (10) formed from individual coils and carrier boards (4) is arranged symmetrically to a central plane of symmetry (30) arranged vertically in relation to the sensor axis (20), wherein a central individual coil of the transmitting coil (3) can lie in the plane of symmetry (30).

6. Device according to any of the preceding claims, **characterized in that** the transmitting coil (3) has a number of n individual coils and the two receiving coils (2) together have a number of at least n+1 individual coils.

7. Device according to any of the preceding claims, **characterized in that** at least one carrier board (4) is in the form of a double carrier board, which has an individual coil on both faces.

8. Device according to Claim 7, **characterized in that** the at least one carrier board (4) in the form of a double carrier board has an individual coil of the receiving coil (2) on one face and an individual coil of the transmitting coil (3) on the other face.

9. Device according to any of the preceding claims, **characterized in that** a head board (5) has precisely four connection pads (7), two connection pads (7) for the receiving coils (2) and two connection pads (7) for the transmitting coil (3).

10. Device according to any of the preceding claims, **characterized in that**, on each individual coil, in particular on the outer individual coils of the receiving coil (2), no conduction paths (14) running transversely to the coil axis (20) for forwarding or connection to a only one in each case one conduction path (14) a head board (5) is provided, which serves as an interface for connection with the circuit (21) and which does not have a coil.

11. Method for detecting a sensing body (50) by means of an inductive proximity sensor (1), wherein the inductive proximity switch (1) has an outside diameter (D1) of equal to or less than 10 mm and is designed according to any of the preceding claims.

## Revendications

1. Capteur de proximité inductif (1) permettant de détecter un corps à détecter (50), comprenant deux bobines réceptrices (2) et une bobine émettrice (3) qui sont formées respectivement à partir d'un groupe d'au moins deux bobines individuelles sur des platines de support (4) qui sont disposées en parallèle l'une à l'autre et de manière axialement décalée sous forme d'empilement (10) le long d'un axe de capteur (20) commun, la bobine émettrice (3) étant disposée entre les deux bobines réceptrices (2), **caractérisé en ce que** les platines de support (4) présentent un diamètre (D) qui est inférieur ou égal à 10 mm, dans lequel l'enroulement (2.1, 3.1) de la bobine réceptrice (2) et/ou de la bobine émettrice (3) présente une géométrie de section transversale pour laquelle le rapport entre la hauteur (H) et la largeur de pied (B) est situé dans la plage de 0,2 à 0,3, idéalement entre 0,23 et 0,27, dans lequel une platine de tête (5) est prévue qui sert d'interface avec des surfaces de connexion (7) pour la connexion à un câblage (100) comprenant un générateur et/ou un oscillateur (90), et qui ne présente aucune bobine.

2. Dispositif selon la revendication 1, **caractérisé en ce que** la hauteur (H) ne dépasse pas 0,05 mm, en particulier ne dépasse pas 0,04 mm.

3. Dispositif selon l'une quelconque des revendications 1 ou 2, **caractérisé en ce que** le nombre d'enroulements d'au moins une bobine individuelle des bobines réceptrices (2) est égal ou supérieur à 3, idéalement égal à 4 ou 5, en particulier égal ou supérieur à 3, idéalement égal à 4 ou 5, pour toutes les bobines individuelles des bobines réceptrices (2).

4. Dispositif selon l'une quelconque des revendications précédentes, **caractérisé en ce que** le nombre d'enroulements d'au moins une bobine individuelle de la bobine émettrice (3) est égal ou supérieur à 3, idéalement égal à 3 ou 4, en particulier égal ou supérieur à 3, idéalement égal à 3 ou 4, pour toutes les bobines individuelles des bobines réceptrices (2).

5. Dispositif selon l'une quelconque des revendications précédentes, **caractérisé en ce que** l'empilement (10) formé par des bobines individuelles et des platines de support (4) est disposé de manière symétrique à un plan de symétrie (30) intermédiaire, disposé verticalement par rapport à l'axe de capteur (20), dans lequel une bobine individuelle intermédiaire de la bobine émettrice (3) peut être située dans le plan de symétrie (30).

6. Dispositif selon l'une quelconque des revendications précédentes, **caractérisé en ce que** la bobine émettrice (3) présente un nombre de n bobines individuelles, et les deux bobines réceptrices (2) présentent ensemble un nombre d'au moins n+1 bobines individuelles.

7. Dispositif selon l'une quelconque des revendications précédentes, **caractérisé en ce qu'**au moins une platine de support (4) est réalisée sous forme de platine de support double qui présente une bobine individuelle des deux côtés.

8. Dispositif selon la revendication 7, **caractérisé en ce que** ladite au moins une platine de support (4), réalisée sous forme de platine de support double, présente sur un côté une bobine individuelle de la bobine réceptrice (2) et sur l'autre côté une bobine individuelle de la bobine émettrice (3).

9. Dispositif selon l'une quelconque des revendications précédentes, **caractérisé en ce qu'**une platine de tête (5) présente exactement quatre surfaces de connexion (7), respectivement deux surfaces de connexion (7) pour les bobines réceptrices (2) et respectivement deux surfaces de connexion (7) pour la bobine émettrice (3).

10. Dispositif selon l'une quelconque des revendications précédentes, **caractérisé en ce que** sur chaque bobine individuelle, en particulier sur les bobines individuelles extérieures de la bobine réceptrice (2) aucune piste conductrice (14) s'étendant transversalement à l'axe de bobine (20) n'est prévue pour la transmission ou la liaison à une seulement une respectivement une piste conductrice (14) une platine de tête (5), qui sert d'interface à la connexion au câblage (21) et qui ne présente aucune bobine.

11. Procédé permettant de détecter un corps à détecter (50) au moyen d'un capteur de proximité inductif (1), dans lequel le commutateur de proximité inductif (1) présente un diamètre extérieur (D1) égal ou inférieur à 10 mm et est réalisé selon l'une quelconque des revendications précédentes.
